# EUROPEAN PATENT APPLICATION

(11) **EP 1 675 188 A2**
(43) Date of publication of application: **28.06.2006**
(21) Application number: 05028005.6
(22) Date of filing: 21.12.2005
(51) Int. Cl.: H01L 31/048, H01L 31/0216

(54) **Solar cell module and the method for installing the same**

(30) Priority: 22.12.2004 JP 2004370312
(71) Applicant: FUJI ELECTRIC HOLDINGS CO., LTD., Kawasaki 210-0858 (JP)
(72) Inventor: Wada, Takehito c/o Fuji Electric Advanced, Yokosuka-shi Kanagawa 240-0194 (JP)
(74) Representative: Hoffmann, Eckart

(57) **Abstract**

The solar cell module (1) according to the invention includes photoelectric converters; surface covering layers made of resins and covering the light incident side of photoelectric converters; and trenches (16) formed in the light-incident-side surface of surface covering layers, trenches (16) being extended approximately in parallel to the horizontal plane for a certain length and in parallel to each other in the surface of solar cell module (1). The solar cell module and the method for installing it according to the invention facilitate, in repairing a damage caused therein, improving the adhesiveness between the module surface and the bonding portion of a repairing stuff, preventing water and contamination from getting into the bonding portion, preventing the solar cell module properties from being degraded, preventing any ground fault from being caused through the water, and preventing the repairing stuff from being peeled.

## Description

The present invention relates to a solar cell module including photoelectric converters and a surface covering layer made of a resin provided to cover the light incident side of the photoelectric converters. The present invention relates also to a method of installing the solar cell module.

The surface of a solar cell module including photoelectric converters, whose light incident side is covered with a surface covering layer made of a resin, is often damaged by vibrations and impacts caused during a transport of the solar cell module for the physical distribution thereof. Especially, solar cell modules including photoelectric converters bonded to a steel plate or a roofing tile and covered only with a resin film without disposing any optical glass plate on the light-incident-side surface thereof, is damaged easily. Damages can be caused by the impact of a falling object during the transport of the solar cell module, by the drop of a tool during the installation of the solar cell module, by the collision of a foothold stuff after the installation of the solar cell module, and by the collision of a falling object during the long term use of the solar cell module.

Through the damages, water and moisture get into the solar cell module, causing contamination. When such surface-damaged solar cell module is used without repair, peeling of the covering layer covering the light-incident surface of a photoelectric converter is caused by the contamination in the sealant. As the peeling advances, the additives in the sealant flow out, causing sealant deterioration and such a defect. This is likely to result in a further deterioration of the properties of the solar cell module.

When the damages are deep, not only a ground fault is caused by water but also corrosion is caused in the photoelectric converter sometimes.

For preventing the troubles caused by the damages in the solar cell module surface from getting worse, various techniques for repairing the surface damages have been proposed, see JP 11-307799 A (1999), for instance.

The proposed techniques prevent the moisture or contamination from getting into the solar cell module by covering the damages in the surface of the solar cell module with an adhesive tape or the like repairing stuff, prevent any fault from occurring in the external appearance of the solar cell module, keep the safety and reliability of the solar cell module, and prevent the performances of the module for a solar cell module from being deteriorated.
In the solar cell module including a light incident side surface covered with a resin, an emboss sheet is on the surface thereof to quicken deaeration during laminating the constituent layers for the solar cell and to further improve the moldability of the solar cell module. In this type of solar cell module, the unevenness on the emboss sheet is reflected by the module surface.

When the damages caused in such uneven surface of the solar cell module are repaired with an adhesive tape, the adhesive tape is bonded by means of its adhesive to the uneven surface of the solar cell module. Therefore, the adhesive tape sticks only to the top portions of the mountains of the uneven surface of the solar cell module, hardly sticking to the entire module surface.

In other words, air layers are caused in the prior art between the valleys of the uneven surface of the solar cell module and the bonding plane of the adhesive tape. Since water and contamination due to rain fall get into the air layers, the properties of the solar cell module are impaired easily and a ground fault is caused easily by the water. The bonding portion of the adhesive tape becomes liable to be peeled due to the water and contamination which have gotten into the air layers.

In view of the foregoing, it is an object of the present invention to provide a solar cell module including photoelectric converters, whose light incident side is covered with a resin surface covering layer, and a method of installing the solar cell module which allow to improve the adhesiveness between the module surface and the bonding portion of a repairing stuff, preventing water and contamination from getting into the bonding portion, preventing the solar cell module properties from being impaired, preventing any ground fault from being caused by the water, and preventing the repairing stuff from peeling.

### SUMMARY OF THE INVENTION

This object is achieved by a solar cell module as claimed in claim 1 and a method of installing it as claimed in claim 3. A preferred embodiment of the invention is subject-matter of the dependent claim.

For one set of solar cell modules, it is preferable to arrange the trenches approximately in parallel to the surface of the pertinent module and in parallel to the horizontal plane of the module. In other words, it is preferable to arrange multiple lines of trenches in the longitudinal direction thereof and multiple rows of trenches in perpendicular to the longitudinal direction thereof.

According to the invention, trenches are formed in the light incident side surface of the surface covering layer covering the light incident side surface of the photoelectric converters of the solar cell module such that the trenches, which have a certain width in the longitudinal direction thereof or widths changing alternately in the longitudinal direction thereof, are extended for a certain length, and the module is mounted on a supporting structure such that the trenches are approximately parallel to the horizontal plane and parallel to each other. Therefore, when damages caused in the module surface are covered with an adhesive tape or the like to use the solar cell module again, water and contamination hardly flow in the longitudinal direction of the trenches and the water and the contamination are prevented from getting into the bonding portion of the repairing stuff in the longitudinal direction of the trenches, i.e. substantially in parallel to the horizontal plane, in the usual mode of installing the solar cell module, in which the solar cell module is mounted on the supporting structure at a certain tilt angle, at which the solar cell module is facing to the solar ray side.

The water and the contamination are prevented from getting into the bonding portion of the repairing stuff from the direction tilting at a certain angle to the longitudinal direction of the parallel trenches by the top surfaces of the land portions between the trenches.

According to the invention, water and contamination are prevented from getting into the bonding portion of the repairing stuff, the performance of the solar cell module is prevented from being impaired by the water and the contamination which have come in, a ground fault and such a trouble are prevented from causing through the water, adhesive force lowering is prevented from causing in the bonding portion of the repairing stuff, the repairing stuff is prevented from being peeled due to the adhesive force lowering, the performances of the solar cell module are stabilized, and the durability of the solar cell module after the repair thereof is improved.

### BRIEF DESCRIPTION OF THE DRAWINGS

- FIG. 1: is a perspective view of solar cell modules showing the mounted state thereof according to a first embodiment of the invention.
- FIG. 2(A): is a cross sectional view of the solar cell module according to the first embodiment of the invention.
- FIG. 2(B): is a top plan view of the solar cell module seen in the direction of the arrow A in FIG. 2(A).
- FIG. 3: is a top plan view of the solar cell module according to the first embodiment showing the repair thereof.
- FIG. 4: is a top plan view of a solar cell module according to a second embodiment of the invention with the trench shape simplified in the Y direction.
- FIG. 5(A): is an expanded cross sectional view of the trenches applicable to the first and the second embodiment of the invention.
- FIG. 5(B): is another expanded cross sectional view of the trench applicable to the first and the second embodiment of the invention.
- FIG. 5(C): is still another expanded cross sectional view of the trench applicable to the first or the second embodiment of the invention.
- FIG. 6(A): is a table comparing the test results for solar cell modules according to the first and the second embodiment of the invention with test results for a comparative solar cell module.
- FIG. 6(B): is a schematic cross sectional view of a rectangular trench describing the test conditions therefor.
- FIG. 6(C): is a schematic cross sectional view of a trapezoidal trench describing the test conditions therefor.
- FIG. 6(D): is a schematic cross sectional view of a semicircular trench describing the test conditions therefor.
- FIG. 7 is: a perspective view of a comparative solar cell module set showing the mounted state thereof.
- FIG.8(A): is a cross sectional view of the comparative solar cell module of FIG. 7.
- FIG.8(B): is a top plan view of the solar cell module seen in the direction of the arrow B shown in FIG. 8(A).

The present invention will be described in detail hereinafter with reference to the accompanying drawings which illustrate preferred embodiments of the invention. Like reference numerals as used for like parts in the Figures described below. Note that the Figures are schematic.

### First embodiment

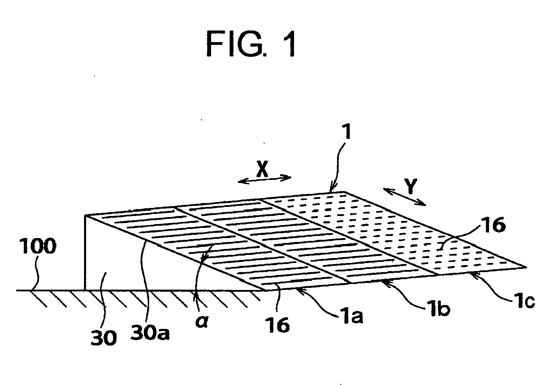

FIG. 1 is a perspective view of a solar cell module set including solar cell modules. FIG. 1 shows the mounted state of the solar cell modules according to the first embodiment of the invention.

In FIG. 1, a solar cell module set 1 including solar cell modules and a module supporting structure 30 are shown. Module supporting structure 30 is tilted relative to the horizontal plane at a tilt angel a. Plural solar cell modules, namely three modules 1 a, 1b, and 1c in this embodiment, are arranged in the lateral direction on the tilted mounting plane 30a of module supporting structure 30. In the following, the reference numeral 1 designates a solar cell module set or solar cell modules collectively.

Solar cell module set 1 may be mounted on the roof of a structure via module supporting structure 30 such that solar cell modules 1 a through 1c and roofing stuff such as roofing tiles are formed into a unit. Alternatively, solar cell module set 1 may be mounted via module supporting structure 30 mounted on a rack disposed on a structure. Still alternatively, solar cell module set 1 may be stuck on a plane or curved wall surface.

Although solar cell module set 1 is tilted preferably southward, as shown in FIG. 1, to receive as much sun light as possible, solar cell module set 1 may be arbitrarily orientated to the west, north or other direction depending on the shape and the tilt of the structure.

In solar cell module set 1, trenches 16 having a certain length are provided to extend in an X-direction substantially in parallel to the horizontal plane and in parallel to each other. "Substantially" in this context means preferably the trenches extend in parallel to each other and to the horizontal plane, but practically unavoidable deviations from this preferred optimum are tolerable. Each trench 16 may extend in the X-direction across substantially the whole module with multiple trenches arranged in parallel to each other as is shown in the solar cell modules 1a and 1b, or, multiple trenches 16 are arranged along a line in the X-direction and multiple rows of such trench lines are arranged in the Y-direction as shown for module 1c.

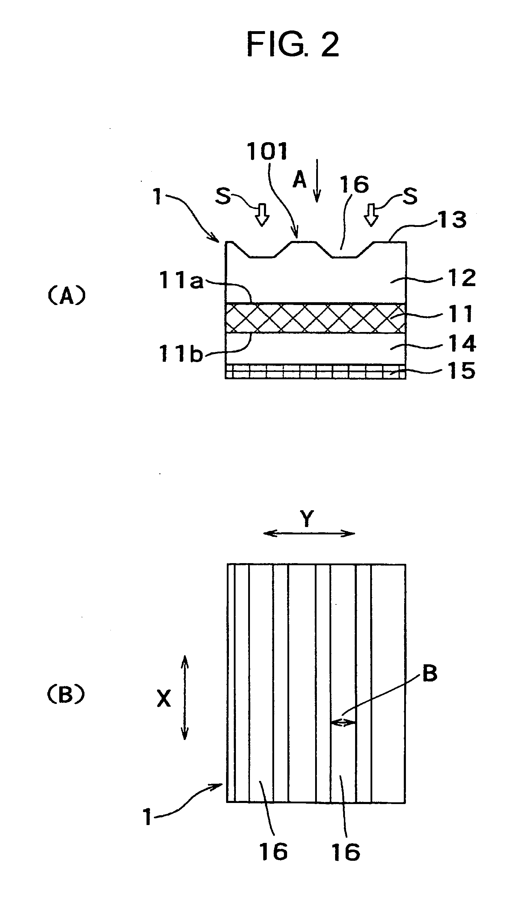

FIG. 2(A) is a cross sectional view of the solar cell module according to the first embodiment of the invention. FIG. 2(B) is a top plan view of the solar cell module seen in the direction of the arrow A in FIG. 2(A).

Referring now to these figures, solar cell module 1 includes a photoelectric converter 11 in the core thereof, a light-incident-side sealing layer 12 and a protector sheet 13 laminated in this order on the light incident side of photoelectric converter 11. Sealing layer 12 and protector sheet 13 constitute a surface covering layer.

On the mounting side of photoelectric converter 11, opposite to the light incident side, a mounting side sealing layer 14 is laminated on a supporting base board 15. Supporting base board 15 serves as a mounting plane, via which solar cell module 1 is mounted on module supporting structure 30.

The trenches 16 having a certain length are formed in the protector sheet 13 and the sealing layer 12 on the side facing away from the photoelectric converter 11. The trenches 16 have, in the example shown in Fig. 2(B) a trapezoidal cross section of a width B at the bottom. Solar cell module 1 is mounted on module supporting structure 30 such that trenches 16 extend in the X-direction approximately parallel to the horizontal plane and in parallel to each other as shown in FIGs. 2(A) and 2(B). In FIG. 2(B), the Y-direction is perpendicular to the X-direction, along which trenches 16 extend.

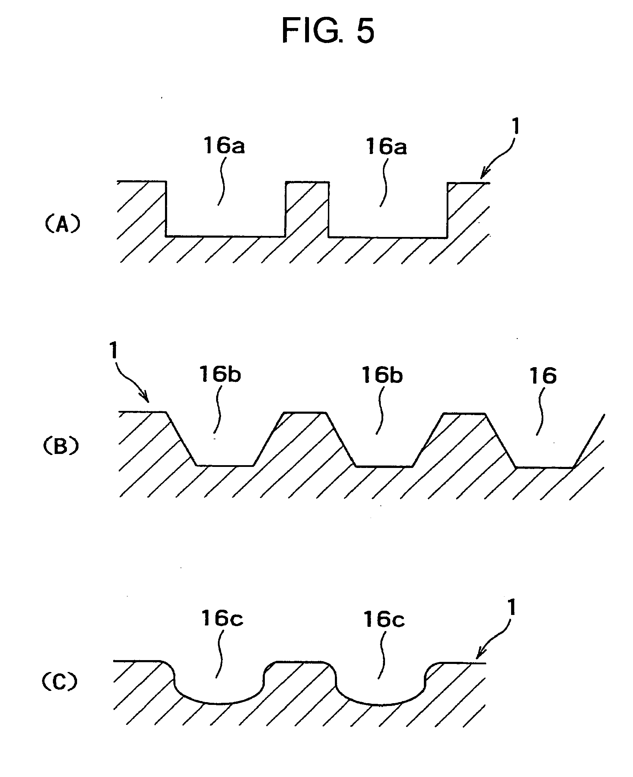

The cross section of the trenches 16 according to the first embodiment may be trapezoidal as in FIG. 5(B), rectangular as in FIG. 5(A) or semicircular as in FIG. 5(C). It is preferably that the shape of the trenches 16 provides a wide contact area with an adhesive tape used for repairing to exhibit high adhesiveness. It is necessary to determine the shape of the trenches 16 considering the relation between the trench shape and the moldability of solar cell module 1.

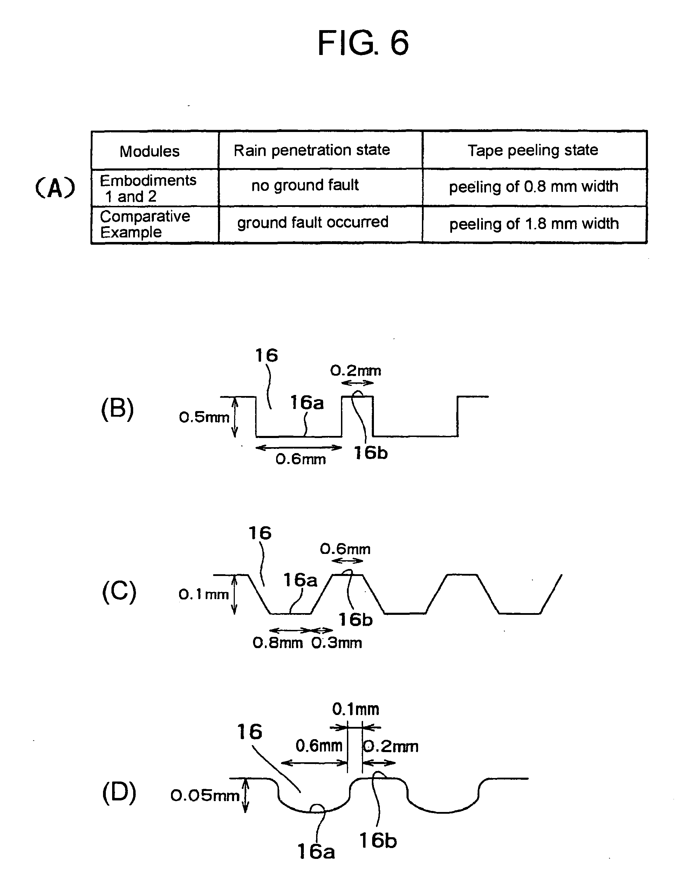

Preferable value ranges for the rectangular shape of the trenches according to Fig. 5(A) are 0.2 to 1 mm for the height (H), 0.3 to 1.2 mm for the bottom width (BW) of a trench and 0.1 to 0.4 mm for the interval (I) between adjacent trenches. In case of Fig. 5(B) the corresponding preferred value ranges are H: 0.05 to 0.2 mm, BW: 0.4 to 1.6 mm, 1: 0.2 to 1.2 mm and 0.2 to 0.6 mm for the projection of a trench's side wall onto the bottom plane. In case of Fig. 5(C) the corresponding preferred value ranges are given by reference to those shown in Fig. 6(D) explained later: the preferred range for the value 0.05 mm in Fig. 6(D) is 0.02 to 0.1 mm, the preferred range for the value 0.6 mm in Fig. 6(D) is 0.3 to 1.2 mm, the preferred range for the value 0.2 mm in Fig. 6(D) is 0.1 to 0.4 mm and the preferred range for the value 0.1 mm in Fig. 6(D) is 0.05 to 0.2 mm.

In solar cell module 1 according to the first embodiment, photoelectric converter 11 includes a metal electrode formed as a film on a polyimide substrate, a photoelectric converting element having a tandem structure of amorphous silicon (a-Si) and amorphous silicon germanium (a-SiGe), and a transparent electrode made of ITO on the light incident side. The tandem structure of a-Si and a-SiGe may be single-layered or triple-layered.

In substitution for the polyimide substrate, a film of any of the following resins such as polyethylene terephthalate (hereinafter referred to as "PET"), polyethylene naphthalate (hereinafter referred to as "PEN"), polyamide, polycarbonate, poly(butylene terephthalate) (hereinafter referred to as "PBT"), polyphenylene sulfide (hereinafter referred to as "PPS"), a liquid crystal polymer, poly(ethyleneimine) (hereinafter referred to as "PEI") and polyamide-imide (hereinafter referred to as "PAI"); a stainless steel substrate; and a glass substrate may be used.

In substitution for a-Si and a-SiGe for the tandem structure of photoelectric converter 11, a-C, a-SiC, microcrystalline silicon (hereinafter referred to as"µc-Si"), µc-SiGe, µc-SiC, and µc-Ge may be used. In substitution for the ITO for the transparent electrode, SnO₂, ZnO and such a transparent electrically conductive film may be used.

Although an ethylene-tetrafluoroethylene copolymer film (hereinafter referred to as "ETFE film") is used for protector sheet 13, a film of polytetrafluoroethylene (hereinafter referred to as "PTFE"), free erythrocyte protoporphyrin (hereinafter referred to as "FEP"), paraformaldehyde (hereinafter referred to as "PFA"), poly(vinylidene difluoride (hereinafter referred to as "PVDF"), and polyvinyl fluoride (hereinafter referred to as "PVF") may be used. Although the surface covering layer on the light incident side of photoelectric converter 11 has a double-layered structure consisting of light-incident-side sealing layer 12 and protector sheet 13 according to the first embodiment of the invention, a triple-layered structure may be used, or a woven glass fiber cloth or a not-woven glass fiber cloth may be inserted.

Although a steel plate is used as the supporting base board 15 on the mounting side, a roofing stuff, an aluminum plate, or a concrete plate may be used instead. Further, photoelectric converter 11 may be bonded or screwed directly to supporting base board 15 without using mounting side sealing layer 14.

The step of bonding protector sheet 13 to photoelectric converter 11 having sealing layer 12 formed thereon is conducted by a vacuum lamination process. For avoiding poor bonding, this lamination is conducted using a peeling sheet having a trench-shaped unevenness on the side of protector sheet 13 mounted on protector sheet 13.

As described later, setting the width B of trenches 16 between 0.5 and 5 mm and the depth thereof between 0.05 and 1 mm is effective for preventing poor bonding in the step of bonding the protector sheet 13 and the sealing layer 12 to a pre-laminated assembly consisting of the photoelectric converter 11, the mounting side sealing layer 14 and the supporting base board 15. The trench pattern as described above is copied to the surface of solar cell module 1 in the step of laminating, determining the surface shape of solar cell module 1.

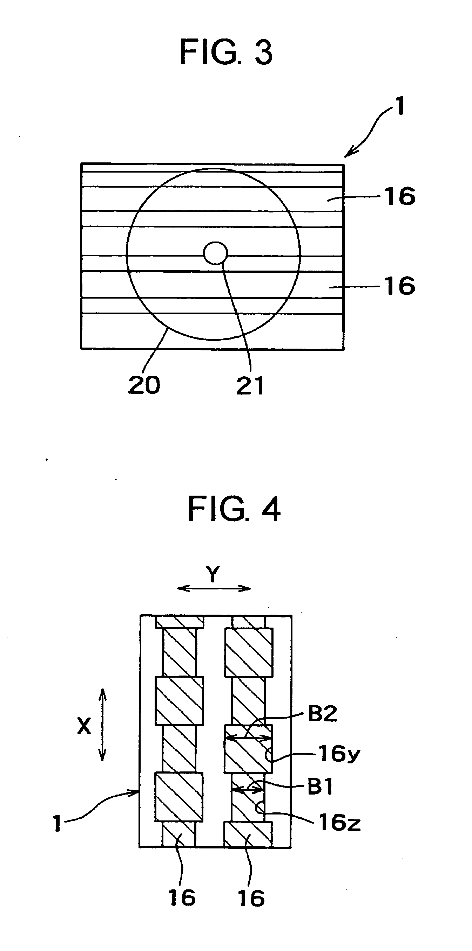

FIG. 3 is a top plan view of solar cell module 1 showing the repair thereof according to the first embodiment of the invention. A damage 21 caused in the surface of solar cell module 1 is covered with an adhesive tape as repairing stuff 20 to repair damage 21. An ETFE film, same as protector sheet 13, to which repairing stuff 20such as an adhesive layer is applied, is used as the repairing stuff 20. Alternatively, a film of any of PTFE, FEP, PFA, PVDF and PVF may be used.

Since the adhesive for pasting repairing stuff 20 to the protector sheet 13 is required to exhibit certain weather resistance, an acrylic adhesive is used. Alternatively, an adhesive or a glue of a butyl rubber material, a silicone material and a thermoplastic material may be used.

### Second embodiment

FIG. 4 is a top plan view of a solar cell module 1 according to a second embodiment of the invention.

The solar cell module 1 according to the second embodiment includes trenches 16, each having narrow sections 16z of width B1 in the Y-direction, and wide sections 16y of width B2 in the Y-direction. B2 is greater than B1. Wide sections 16y and narrow sections 16z of each trench 16 are arranged alternately in the X-direction. The sequences of wide and narrow sections of adjacent trenches 16 are shifted relative to each other in the X-direction, so that a narrow section 16z of one trench opposes a wide section 16y of the neighboring trenches. Although not illustrated, the width B of trenches 16 may be changed continuously (wave-like) instead of stepwise as in Fig. 4. The other structures and functions are the same as those of the solar cell module according to the first embodiment.

### Comparative example

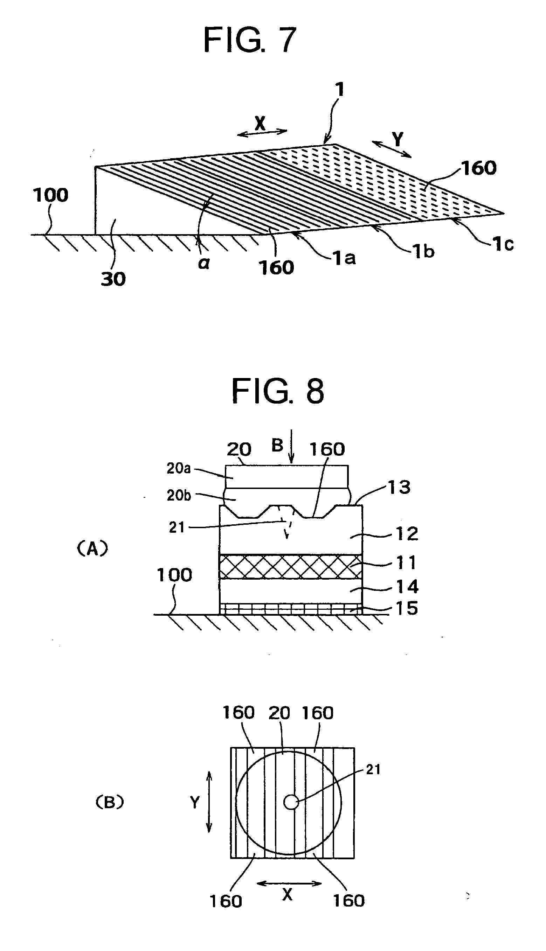

FIG. 7 is a perspective view of a comparative solar cell module set. FIG.8(A) is a cross sectional view of the comparative solar cell module of FIG. 7. FIG.8(B) is a top plan view of the solar cell module seen in the direction of the arrow B shown in FIG. 8(A). Note that in Fig. 8, the trench shape is exaggerated in the longitudinal direction, and 20a and 20b represent a film and an adhesive layer, respectively, of a transparent tape.

Referring now to FIG. 7, a solar cell module set 1 of this comparative example differs from that of the first embodiment in that trenches 160 extend across solar cell modules 1a and 1b in the Y-direction rather than the X-direction. Apart from that the trenches 160 are shaped in the same manner as the trenches 16 according to the first or those of the second embodiment.

In other words, trenches 160 in FIG. 7 extend perpendicular to the trenches 16 in FIG. 1. The comparative solar cell module set 1 is mounted on mounting plane 30a of module supporting member 30 such that the width direction of trenches 160 is in the X-direction approximately parallel to the horizontal plane 100, the longitudinal direction of the trenches 160 is in the Y-direction perpendicular to the X-direction, and trenches 160 are arranged parallel to each other in the X-direction.

When a damage 21 is caused in the surface of the comparative solar cell module 1, damage 21 is repaired by covering it with repairing stuff 20 like an adhesive tape as shown in FIG. 8(B). Since a gap is liable to be caused between repairing stuff 20 and the surface of solar cell module 1 in FIG. 8(A), water and contamination flow in the longitudinal direction of trenches 160 in FIG. 7, i.e. in the Y-direction, and, then, happen to get into the bonding portion of repairing stuff 20 forming the gap. Due to the penetration of the water and contamination, the adhesive force of repairing stuff 20 is impaired, it liable to peel from the surface of solar cell module 1.
According to the first embodiment, trenches 16, having a certain length and extended parallel to each other, are formed in the light incident side surface of a surface covering stuff (formed of light-incident-side sealing stuff 12 and protector sheet 13) covering the light incident side surface of photoelectric converter in solar cell module 1, and solar cell module 1 is mounted on module supporting stuff 30 in such an orientation that all the trenches 16 are extending in the X-direction substantially in parallel to the horizontal plane 100. According to the second embodiment, trenches 16, each having narrow sections, the width thereof is B1, and wide sections, the width B2 thereof is wider than B1, arranged alternately in the longitudinal direction thereof, are formed in the light incident side surface of a surface covering stuff (formed of light-incident-side sealing stuff 12 and protector sheet 13) covering the light incident side surface of photoelectric converter in solar cell module 1, and solar cell module 1 is mounted on module supporting stuff 30 in such an orientation that all the trenches 16 are extending in the X-direction substantially in parallel to the horizontal plane 100. Trenches 16 are parallel to each other in the Y-direction perpendicular to the X-direction.

In the first and the second embodiment described above, solar cell module 1, having damages caused in the surface thereof and covered with repairing stuff 20 such an adhesive tape, is mounted on supporting structure 30 to use solar cell module 1 again in the usual mode of installation at a certain tilt angle α, at which the solar cell module is facing to the solar ray side. When solar cell module 1 is used in the usual mode of installation, water and contamination hardly flow in the longitudinal direction of the trenches, i.e. the X-direction substantially parallel to the horizontal plane 100, and the water and the contamination are prevented from getting into from the Y-direction, i.e. the direction perpendicular to the longitudinal direction of trenches 16, by the top surfaces of the land portions between trenches 16.

The tilt angle is preferably an angle at which the solar cell module is optimally exposed to the solar light. An example of the tilt angle is an angle corresponding to solar light falling perpendicularly or nearly perpendicularly on the solar cell module at a meridian passage in the northern hemisphere. However, the tilt angle may take various values depending on the condition of installation of the solar cell module or other factors.

According to the first and second embodiments of the invention, water and contamination are prevented from getting into the bonding portion of repairing stuff 20, the properties of the solar cell module are prevented from being impaired by the water and contamination which have come in, a ground fault and like trouble are prevented from being caused by the water, the adhesive force is prevented lowering of repairing stuff 20 strongly bonded and prevent it from being peeled by the adhesive force lowering, the performances of solar cell module 1 are stabilized, and the durability of solar cell module 1 after the repair thereof is improved.

### Comparing tests and results

FIG. 6(B) is a schematic cross sectional view of a rectangular trench describing the test conditions therefor. FIG. 6(C) is a schematic cross sectional view of a trapezoidal trench describing the test conditions therefor. FIG. 6(D) is a schematic cross sectional view of a semicircular trench describing the test conditions therefor.

For comparing, a solar cell module 1 was pasted to a steel plate of 0.8 mm thickness so that trenches 16 in the surface of the solar cell module 1 were aligned substantially parallel to the horizontal plane 100. Trenches 16 in this comparison were rectangular in cross section perpendicular to the longitudinal direction thereof as shown in FIG. 6(B). The trenches 16 were 0.5 mm in depth and 0.6 mm in width. The width of the land between trenches 16 was 0.2 mm..

An ethylene-vinyl acetate copolymer film (hereinafter referred to as an "EVA film") of 0.7 mm thickness was used as the sealing layer 12 on the light-incident-side side. An ETFE film of 0.05 mm thickness was used as the protector sheet 13. The lamination conditions for the vacuum lamination process included deaeration at 120 °C for 2 min, curing at 155 °C for 20 min under a pressurized state, and release from the lamination process after lowering the temperature down to 80 °C.

A needle having a point angle of 60 degrees, under a load of 9,8 N, was made to fall from a height of 10 cm onto solar cell module 1 configured as described above. The damage reached the cell of module 1. The damaged module was dipped into water to evaluate the insulation performance thereof. The insulation resistance lowered down to 60 MΩ or lower. Then, an adhesive tape was pasted onto the damaged solar cell module such that the distance between the damage and the edge of the adhesive tape was 20 mm. Then, a force of 98 N was exerted to the adhesive tape using a roll of 100 mm in width to bond the adhesive tape to solar cell module 1 under pressure.

Solar cell module 1 repaired as described above was installed on a plane, facing southward and tilted at 30 degrees, exposed for one year, and then evaluated after the final rain fall is over. The evaluation included external appearance inspection for confirming the rain water penetration into the gap between the adhesive tape and the module and inspection of the peeling states of the adhesive tape.

The results obtained by the tests described above are listed in the table shown in FIG. 6(A). As indicated in the table, no ground fault was caused by the penetration of rain water into the gap in the solar cell module according to any of the embodiments of the invention. A peeling of 0.8 mm in width was observed in a row of trench 16.

Similar tests as the above described tests were conducted on a solar cell module 1 with the trapezoidal trenches of Fig. 5(B) and a solar cell module 1 with the semicircular trenches of Fig. 5(B), and similar results as the above described results were obtained.

Comparative solar cell modules (having trenches extending substantially in parallel to the tilting plane) were fabricated under the same conditions, under which the solar cell modules according to the first and second embodiments were manufactured, and evaluated under the same conditions, under which the solar cell modules according to the first and second embodiments were evaluated. As indicated in the table of FIG. 6(A), water got into the bonding portion of the adhesive tape and caused a ground fault. Wide peeling of 1.8 mm in width has been confirmed. Contamination has been confirmed on the peeling surface.

The comparative tests confirm the superiority of solar cell module 1 according to each of the embodiments of the invention.

## Claims

1. A solar cell module (1 a, 1 b, 1 c) comprising:
photoelectric converters (11) including a light incident side surface covered with a surface covering layer (12, 13) wherein the plane defined by the light incident side surface of the surface covering layer (12, 13) is tilted parallel to the horizontal plane;
trenches (16) in the light incident side surface, the trenches (16) being extended substantially in parallel to the horizontal plane and arranged substantially in parallel to each other in the surface of the solar cell module.

2. The solar cell module (1a, 1b, 1c) according to Claim 1, wherein the trenches (16) have a certain width in the horizontal direction thereof.

3. A method of installing a solar cell module (1a, 1b, 1c) having one or more photoelectric converters (11) including a light incident side surface covered with a surface covering layer (12, 13), the method comprising:
mounting the solar cell module (1a, 1b, 1c) having trenches in the light incident side surface such that the trenches are extending for a certain length, on a module supporting structure (30) such that the trenches (16) are extending substantially in parallel to the horizontal plane and such that the trenches (16) are extending in parallel to each other.
